# EUROPEAN PATENT APPLICATION

(11) **EP 2 590 223 A2**
(43) Date of publication of application: **08.05.2013**
(21) Application number: 12166669.7
(22) Date of filing: 03.05.2012
(51) Int. Cl.: H01L 31/0236

(54) **Solar cell**

(30) Priority: 03.11.2011 KR 20110114028
(71) Applicant: Samsung SDI Co., Ltd., Yongin-si, Gyeonggi-do (KR)
(72) Inventor: Park, Joong-Hyun, Gyeonggi-do (KR); Shin, Myung-Hun, Gyeonggi-do (KR)
(74) Representative: Mounteney, Simon James

(57) **Abstract**

A solar cell with improved photoelectric conversion efficiency is disclosed. The cell solar cell includes a substrate, along with a reflection electrode layer, a light absorption layer, and a transparent layer sequentially laminated on the substrate. The reflection electrode layer includes a first electrode layer contacting the substrate, nanoparticles on the first electrode layer, and a second electrode layer on the first electrode layer and covering the nanoparticles. The second electrode layer has a first surface-roughness of nanometer (nm) scale.

## Description

### BACKGROUND

### 1. Field

The present invention relates generally to a solar cell.

### 2. Description of Related Art

A solar cell is a photoelectric conversion device that converts solar light energy into electric energy. Solar cells may be classified, for example, into a silicon solar cell using silicon as a light absorption layer (or a photoelectric conversion layer), a compound semiconductor solar cell using compounds such as CIS (Cu, In, Se), CIGS (Cu, In, Ga, Se), or the like. Cu, In, Ga, and Se are chemical abbreviations for copper, indium, gallium, and selenium, respectively. Various research efforts are directed to improving the photoelectric conversion efficiency of solar cells.

The above information disclosed in this Background section is only for enhancement of understanding of the background of the described technology and therefore it may contain information that does not form the prior art that is already known in this country to a person of ordinary skill in the art.

### SUMMARY

The present invention sets out to provide a solar cell having improved photoelectric conversion efficiency by providing a structure that focuses more light energy into the light absorption layer inside the solar cell.

Accordingly, the invention provides a solar cell that includes a substrate along with a reflection electrode layer, a light absorption layer, and a transparent electrode layer sequentially laminated on the substrate. The reflection electrode layer includes a first electrode layer contacting the substrate, nanoparticles on the first electrode layer, and a second electrode layer on the first electrode layer and covering the nanoparticles. The second electrode layer has a first surface-roughness of nanometer (nm) scale.

The first electrode layer may have a flat surface facing the second electrode layer.

The nanoparticles may constitute a single layer with intervals separating adjacent ones of the nanoparticles.

The second electrode layer may have a thickness larger than radii of the nanoparticles.

The nanoparticles may have sizes ranging from 50 nm to 400 nm.

The nanoparticles may constitute a single layer with intervals ranging from 100 nm to 800 nm separating adjacent ones of the nanoparticles.

The single layer of nanoparticles and the intervals separating the adjacent ones of the nanoparticles may be a result of using a spin coating method.

The nanoparticles may include least one metal nanoparticle selected from the group consisting of gold (Au), silver (Ag), platinum (Pt), palladium (Pd), aluminum (Al), copper (Cu), nickel (Ni), zinc (Zn), iron (Fe), and molybdenum (Mo).

The light absorption layer may have the first surface-roughness on one surface facing the reflection electrode layer.

The light absorption layer may include at least one compound semiconductor selected from the group consisting of CuInSe, CuInSe₂, CuInGaSe and CuInGaSe₂ and CdTe.

The solar cell may further include a buffer layer between the light absorption layer and the transparent electrode layer. The buffer layer may include at least one material selected from the group consisting of cadmium sulfide (CdS), zinc sulfide (ZnS), and indium oxide (In₂O₃).

The transparent electrode layer may include a front surface for facing incident solar light. The front surface of the transparent electrode layer may have a second surface-roughness separate from the first surface-roughness.

The transparent electrode layer may include at least one material selected from the group consisting of zinc oxide doped with boron (BZO), zinc oxide (ZnO), indium oxide (In₂O₃), and indium tin oxide (ITO),

According to exemplary embodiments of the present invention, it is possible to improve or maximize the light scattering effect of the reflection electrode layer by using nanoparticles. In addition, it is possible to improve the photoelectric conversion efficiency by focusing more solar light into the light absorption layer to increase the light utilization rate, Further, it is possible to increase the long wavelength absorbance of the light absorption layer because the reflection electrode layer efficiently scatters the light having a long wavelength.

At least some of the above and other features of the invention are set out in the claims.

### BRIEF DESCRIPTION OF THE DRAWINGS

FIG. 1 is a schematic cross-sectional view of a solar cell according to an embodiment of the present invention,

FIG. 2 is a partial enlarged view of the solar cell shown in FIG. 1.

FIG. 3 shows incident light and scattering light by a reflection electrode layer in the solar cell shown in FIG. 1.

FIG. 4 is a graph showing simulation results of the absorbance change of a CIGS (Cu, In, Ga, Se) light absorption layer with respect to the wavelength of solar light in Examples 1 to 3 of embodiments of the present invention and Comparative Examples 1 to 3 of comparative implementations.

### DETAILED DESCRIPTION

The present invention will be described more fully hereinafter with reference to the accompanying drawings, in which embodiments of the present invention are shown. As those skilled in the art would realize, the described embodiments may be modified in various different ways, all without departing from the scope of the present invention.

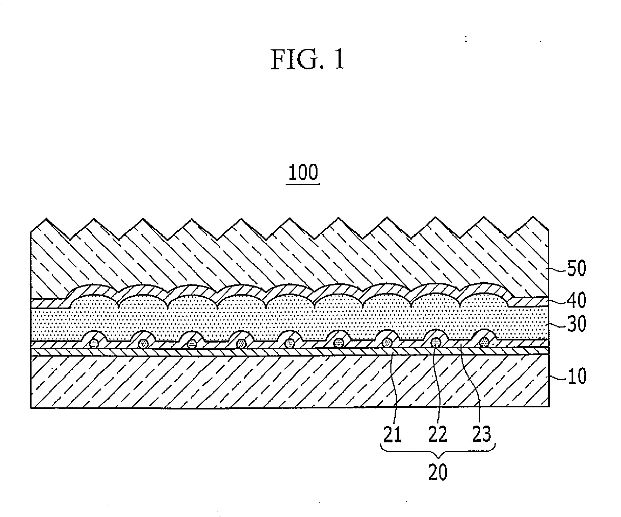

In an embodiment of the present invention (see, for example, FIG. 1), a solar cell may include a transparent electrode layer positioned with a front surface facing incident solar light, along with a light absorption layer and a reflection electrode layer that are positioned at a back surface of the transparent electrode layer. The solar light transmits through the transparent electrode layer to the light absorption layer. Some of this solar light further transmits through the light absorption layer to the reflection electrode layer. The reflection electrode layer then reflects the solar light transmitting through the light absorption layer to help focus the solar light into the light absorption layer. The light absorption layer produces electrons and holes using the light energy from the solar light.

The amount of solar light focused into the light absorption layer may be further improved by, for example, forming an anti-reflective layer on the front surface of the transparent electrode layer, increasing surface roughness of the transparent electrode layer, or the like. When applying such techniques, it is possible to improve the photoelectric conversion efficiency of the solar cell by directing more solar light to the light absorption layer.

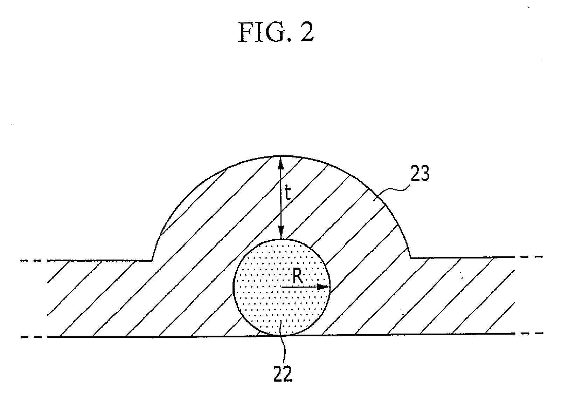

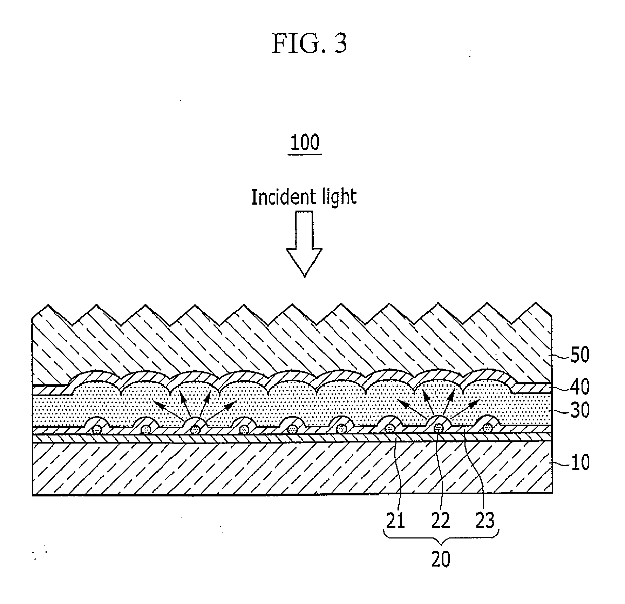

FIG. 1 is a schematic cross-sectional view of a solar cell 100 according to a first embodiment of the present invention, FIG. 2 is a partial enlarged view of the solar cell 100 shown in FIG, 1, and FIG. 3 shows incident light and scattering light by a reflection electrode layer 20 in the solar cell 100 shown in FIG. 1.

Referring to FIGS. 1 to 3, the solar cell 100 includes a substrate 10, the reflection electrode layer 20, a light absorption layer 30, a buffer layer 40, and a transparent electrode layer 50. The solar cell 100 may be a silicon solar cell using silicon as the light absorption layer 30, or a compound semiconductor solar cell having the light absorption layer 30 containing cadmium telluride (CdTe), CIS (Cu, In, Se), or CIGS (Cu, In, Ga, Se). Hereinafter, a light absorption layer 30 containing CIS or CIGS is described as an example.

The substrate 10 is at the back of the solar cell 100. That is, the substrate 10 is positioned farthest from the surface to which the solar light is incident (that is, the front surface of the transparent electrode layer 50). The substrate 10 may be formed of various materials such as a glass substrate, a ceramic substrate, a stainless steel sheet, a metal substrate, or a polymer film.

The reflection electrode layer 20 is on the substrate 10. The reflection electrode layer 20 has high light reflection efficiency, and is formed of a metal having excellent adhesion with the substrate 10. For example, the reflection electrode layer 20 may include molybdenum (Mo). Molybdenum (Mo) has high electric conductivity, forms ohmic contact or schottky contact with the light absorption layer 30, and implements high stability in a high temperature heat treatment process for forming the light absorption layer 30.

The reflection electrode layer 20 includes a first electrode layer 21 contacting the substrate 10, nanoparticles 22 dispersedly positioned (e.g., constituting a single layer) on the first electrode layer 21, and a second electrode layer 23 positioned on the first electrode layer 21 while covering the nanoparticles 22. The second electrode layer 23 forms a rugged structure of nanometer scale by the nanoparticles 22 to improve the light scattering degree of the reflection electrode layer 20. The nanometer (nm) scale is a size in the range of from 1 nm to less than 1,000 nm.

The first electrode layer 21 is formed at a constant thickness on the substrate 10, and forms a flat surface toward the second electrode layer 23. The first electrode layer 21 may maintain high adhesion with the substrate 10.

It should be noted that when the nanoparticles are disposed directly on the substrate, the adhesion between the substrate and the first electrode layer may be reduced, and therefore, the first electrode layer may be peeled from the substrate in the high temperature heat treatment process for forming the light absorption layer. Accordingly, the nanoparticles 22 of the embodiment of FIGS. 1-3 are disposed between the first electrode layer 21 and the second electrode layer 23, so that the adhesion of the first electrode layer 21 for the substrate 10 is increased to prevent the peeling of the first electrode layer 21.

The nanoparticles 22 provide the rugged structure of nanometer scale to the second electrode layer 23. This increases the light scattering on the surface of the reflection electrode layer 20 when compared to a reflection electrode implemented as a single metal film having a flat surface.

The solar light sequentially transmits through the transparent electrode layer 50 and the buffer layer 40 before reaching the light absorption layer 30. Some of this solar light further transmits through the light absorption layer 30, where it is reflected by the reflection electrode layer 20 back toward the light absorption layer 30. The reflection electrode layer 20 efficiently scatters light having a long wavelength of 1 µm or more, thus improving the long wavelength absorbance of the light absorption layer 30. The reflection electrode layer 20 further provides reflection, thereby focusing the light toward the light absorption layer 30.

The nanoparticles 22 may have sizes ranging from 50 nm to 400 nm. When the size of the nanoparticles 22 is under 50 nm, the long wavelength scattering effect is reduced, such that it is difficult to increase the photoelectric conversion efficiency. When the size of the nanoparticles 22 is over 400 nm, the long wavelength scattering effect is increased, but the second electrode layer 23 becomes too thick, which may increase production costs and lengthen the process time. Accordingly, in this particular embodiment of the present invention, the nanoparticles 22 have sizes ranging from 200 nm to 300 nm.

The nanoparticles 22 are spaced apart from each other without attaching to each other, and may be disposed at regular distances from each other. In this case, the second electrode layer 23 forms uniform protrusions and depressions to efficiently scatter the solar light incident to the reflection electrode layer 20.

Considering such a matter, the distance between the nanoparticles 22 (e.g., the intervals between adjacent nanoparticles 22) may be in the range of 100 nm to 800 nm. When the distance between the nanoparticles 22 is under 100 nm, the nanoparticles 22 are clumped together and may be peeled during the high temperature heat treatment process. When the distance between the nanoparticles 22 is over 800 nm, the density of the nanoparticles 22 is too low, such that the long wavelength scattering effect may be insignificant. Accordingly, in this particular embodiment of the present invention, the distance between the nanoparticles 22 is in the range of 200 nm to 300 nm.

The second electrode layer 23 covers all the nanoparticles 22 so that the nanoparticles 22 are not exposed to the light absorption layer 30. The second electrode layer 23 may be formed by sputtering and thus, the second electrode layer 23 formed by the sputtering may have a degraded step coverage.

Considering the sputtering characteristic, the second electrode layer 23 may be formed at a larger thickness than the radius (radii) of the nanoparticles 22. For example, the thickness of the second electrode layer 23 may range from 25 nm to 200 nm. In FIG. 2, the radius of the nanoparticles 22 is denoted by R and the thickness of the second electrode layer 23 is denoted by t. When this condition is met, the nanoparticles 22 may be surrounded by the second electrode layer 23 without a portion exposed toward the light absorption layer 30. Accordingly, the second electrode layer 23 can obtain high electrical conductivity.

When a portion of the nanoparticles is exposed toward the light absorption layer, or when the nanoparticles are disposed on the second metal layer, the nanoparticles have an adverse effect on CIS or CIGS crystal growth. This, in turn, generates characteristic degradation in the process of the high temperature heat treatment for forming the light absorption layer.

However, in the embodiment of FIGS. 1-3, the second electrode layer 23 covers all the nanoparticles 22. Accordingly, the nanoparticles 22 are not exposed toward the light absorption layer 30, thereby reducing or preventing the characteristic degradation of the light absorption layer 30.

The above-mentioned nanoparticles 22 may be dispersedly placed on the first electrode layer 21 using a low-cost process such as spin coating without a separate patterning process such as photolithography. For example, a method for uniformly mixing the dispersed liquid with nanoparticles, spin coating the dispersed liquid on the first electrode layer 21, and then evaporating the dispersed liquid by a drying process may be applied.

The nanoparticles 22 may include metal nanoparticles such as gold (Au), silver (Ag), platinum (Pt), palladium (Pd), aluminum (Al), copper (Cu), nickel (Ni), zinc (Zn), iron (Fe), molybdenum (Mo), and the like. The metal nanoparticles cause a surface roughness of the reflection electrode layer 20 to improve the degree of light scattering and to improve absorbance of the light absorption layer 30 by using surface plasmon resonance (SPR).

Surface plasmon resonance (SPR) refers to a phenomenon in which, when radiating light of specific wavelengths to the metal nanoparticles, the internal charge distribution of the metal nanoparticles is changed and a light intensity is amplified. Using this phenomenon, efficiency of the solar cell 100 may be improved by amplifying light of the wavelength region that cannot be easily absorbed by the light absorption layer 30.

However, the light amplification effect due to the surface plasmon resonance (SPR) is applied only around the metal nanoparticles. In the solar cell 100 of the embodiment of FIGS. 1-3, the nanoparticles 22 are located close to the light absorption layer 30, having the second electrode layer 23 having a thickness of nanometer scale therebetween. Therefore, the nanoparticles 22 amplify the solar light around the lower portion of the light absorption layer 30 in contact with the reflection electrode layer 20 to improve the light utilization efficiency.

The light absorption layer (or photoelectric conversion layer) 30 is located over the above-mentioned reflection electrode layer 20. The light absorption layer 30 generates electrons and holes using light energy transmitted through the transparent electrode layer 50 and the buffer layer 40. The light absorption layer 30 may include any one or more of chalcopyrite-based compound semiconductors selected from the group consisting of CuInSe, CulnSe₂, CuInGaSe, and CuInGaSe₂. The chalcopyrite-based compound semiconductors have an energy band gap of about 1.2 electronvolts (eV).

The light absorption layer 30 may be produced by, for example: (1) sputtering copper (Cu) and indium(In), or copper (Cu), indium(In), and gallium (Ga) on the reflection electrode layer 20 to form a precursor layer; (2) thermal evaporating selenium (Se) and sulfur (S) on the precursor layer; and (3) performing rapid heat treatment at high temperature of 550°C or more for more than one minute to grow a CIS (Cu, In, Se) or CIGS (Cu, In, Ga, Se) crystal.

Sulfur thermally deposited together with selenium serves to prevent evaporation of selenium (Se) in a rapid heat treatment process. In this case, the operating voltage of the solar cell 100 can become higher by increasing an energy band gap of the light absorption layer 30,

The light absorption layer 30 is formed on the reflection electrode layer 20 in which the surface roughness is formed, such that the surface roughness also becomes part of the light absorption layer 30. The surface roughness of the light absorption layer 30 improves the light utilization efficiency of the solar cell 100 by reducing external light reflection that occurs between the buffer layer 40 and the light absorption layer 30, or between the transparent electrode layer 50 and the light absorption layer 30 when the buffer layer 40 is omitted.

The buffer layer 40 may be located over the light absorption layer 30. The buffer layer 40 serves to alleviate the difference in the energy band gap between the light absorption layer 30 and the transparent electrode layer 50. In addition, the buffer layer 40 alleviates the difference between lattice constants of the light absorption layer 30 and the transparent electrode layer 50 to preferably join the two layers 30 and 50.

The buffer layer 40 may include any one or more of cadmium sulfide (CdS), zinc sulfide (ZnS), and indium oxide (In₂O₃). The energy band gap of cadmium sulfide (CdS) is approximately 2.4 eV. The buffer layer 40 also has the surface roughness that is formed by the surface roughness of the light absorption layer 30, as illustrated in FIGS. 1 and 3. The buffer layer 40 may be omitted in other embodiments.

The transparent electrode layer 50 is located over the buffer layer 40 and includes a back surface facing the buffer layer and a front surface facing the incident solar light. The transparent electrode layer 50 may include boron doped zinc oxide (BZO) having an excellent light transmittance. BZO may be grown using an organic metal chemical vapor deposition (metal organic CVD, MOCVD) technology. In this case, the organic metal source used is low cost and may form the BZO transparent electrode layer 50 having better step coverage than with sputtering.

On the other hand, the transparent electrode layer 50 may be made of other metal oxides including zinc oxide (ZnO), indium oxide {In₂O₃), indium tin oxide (ITO), and the like. Zinc oxide (ZnO) has an energy band gap of about 3.37 eV. Such a transparent electrode layer 50 has a high electrical conductivity and high light transmittance.

The transparent electrode layer 50 forms the surface roughness from the surface roughness of the light absorption layer 30 and the buffer layer 40. In addition, the front surface of the transparent electrode layer 50 may form a rougher surface by a separate texturing process (see, for example, the front surface of the transparent electrode layer in FIGS. 1 and 3). In addition to or in place of the texturing process, an anti-reflective layer may be further formed over the transparent electrode layer 50. The formation of the surface roughness (including the additional roughness of the front surface by the separate texturing process) and the anti-reflective layer of the transparent electrode layer 50 reduces an external light reflection to increase transmission efficiency of sunlight to the light absorption layer 30.

The solar cell 100 of the embodiment of FIGS. 1-3 uses the nanoparticles 22 to increase or maximize the light-scattering effect of the reflection electrode layer 20. Therefore, the light absorption layer 30 can collect more sunlight to increase a light utilization rate, thereby improving the photoelectric conversion efficiency. In addition, the reflection electrode layer 20 effectively scatters light having a long wavelength to increase absorbance of the long-wavelength light in the light absorption layer 30.

The solar cell 100 may also use CdTe as the light absorption layer 30. Further, the solar cell 100 may be configured as a silicon solar cell using silicon as the light absorption layer 30 in addition to the above-mentioned compound semiconductor solar cells. In addition, the structure of the solar cell 100 is applicable to all the known substrate-type solar cells.

A solar cell may be classified as having a superstrate structure or a substrate structure. The superstrate structure is a structure in which sunlight reaches the absorption layer through the substrate and the substrate structure is a structure in which the sunlight reaches the light absorption layer through the transparent electrode layer, which may be the final layer on the substrate. In general, solar cells having the substrate structure have higher photoelectric conversion efficiency than the solar cells having the superstrate structure.

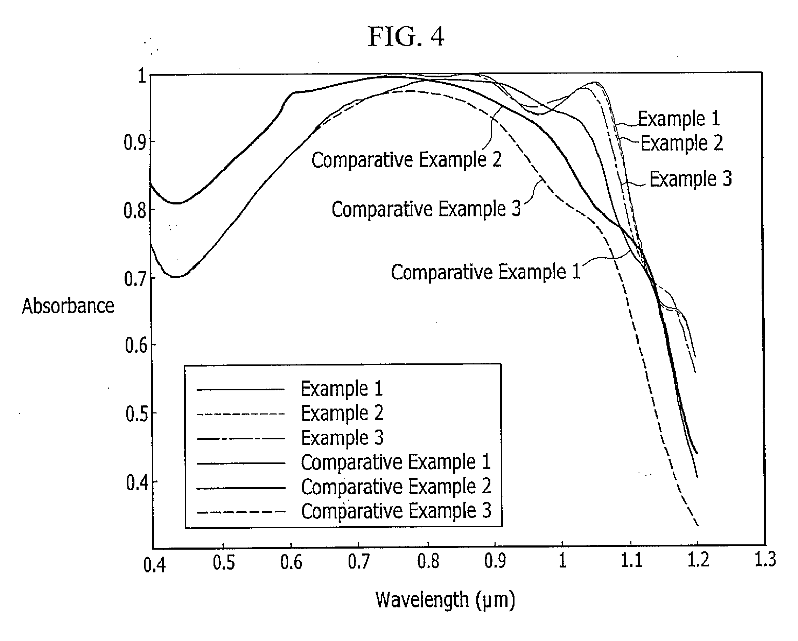

FIG. 4 is a graph showing simulation results of the absorbance change of the CIGS light absorption layer with respect to the wavelength of sunlight in Examples 1 to 3 of embodiments of the present invention and in Comparative Examples 1 to 3 of comparative implementations.

Referring to FIG, 4, Examples 1 to 3 correspond to cases in which the nanoparticles made of silver (Ag, Example 1), gold (Au, Example 2), and aluminum (Al, Example 3), respectively, are placed between the first electrode layer and the second electrode layer configuring the reflection electrode layer. In Examples 1 to 3, the transparent electrode layer forms the surface having additional roughness on the front surface through the separate texturing process. In Examples 1 to 3, the nanoparticles have an average size of 200 nm and are located apart from each other at a distance of approximately 200 nm.

Comparative Examples 1 to 3, on the other hand, correspond to cases in which the reflection electrode layer is flatly formed as a single metal film. In Comparative Example 1, nanoparticles made of aluminum (Al) are disposed over the reflection electrode layer. In Comparative Examples 2 to 3, the nanoparticles are not used, In Comparative Example 2, the transparent electrode layer is formed with the separate texturing process on the front surface to increase surface roughness. In Comparative Examples 1 and 3, the transparent electrode layer is formed without the separate texturing process.

Referring to FIG. 4, it can be confirmed that the absorbance of Examples 1 to 3 is higher than that of Comparative Examples 1 to 3 in a long wavelength area of 1 µm to 1.1 µm. The result is obtained because the long wavelength scattering effect is increased due to the surface roughness of the reflection electrode layer by the metal nanoparticles.

While the present invention has been described in connection with what is presently considered to be practical embodiments thereof, it is to be understood that the present invention is not limited to the disclosed embodiments, but, on the contrary, is intended to cover various modifications and equivalent arrangements included within the scope of the appended claims, and equivalents thereof.

## Claims

1. A solar cell, comprising:
a substrate; and
a reflection electrode layer, a light absorption layer, and a transparent electrode layer sequentially laminated on the substrate,
wherein the reflection electrode layer comprises:
a first electrode layer contacting the substrate;
nanoparticles on the first electrode layer; and
a second electrode layer on the first electrode layer and covering the nanoparticles, the second electrode layer having a first surface-roughness of nanometer (nm) scale.

2. A solar cell according to claim 1, wherein the first electrode layer has a flat surface facing the second electrode layer.

3. A solar cell according to claim 1 or 2, wherein the nanoparticles have sizes ranging from 50 nm to 400 nm.

4. A solar cell according to any preceding claim, wherein the second electrode layer has a thickness larger than radii of the nanoparticles.

5. A solar cell according to any preceding claim, wherein the nanoparticles constitute a single layer with intervals separating adjacent ones of the nanoparticles.

6. A solar cell according to claim 5, wherein the nanoparticles constitute a single layer with intervals ranging from 100 nm to 800 nm separating adjacent ones of the nanoparticles.

7. A solar cell according to claim 5 or 6, wherein the single layer of nanoparticles and the intervals separating the adjacent ones of the nanoparticles are a result of using a spin coating method.

8. A solar cell according to any preceding claim, wherein the nanoparticles comprise at least one metal nanoparticle selected from the group consisting of gold (Au), silver (Ag), platinum (Pt), palladium (Pd), aluminum (Al), copper (Cu), nickel (Ni), zinc (Zn), iron (Fe), and molybdenum (Mo).

9. A solar cell according to any preceding claim, wherein the light absorption layer has the first surface-roughness on one surface facing the reflection electrode layer.

10. A solar cell according to any preceding claim, wherein the light absorption layer comprises at least one compound semiconductor selected from the group consisting of CufnSe, CuInSe₂, CuInGaSe and CuInGaSe₂ and CdTe.

11. A solar cell according to any preceding claim, further comprising a buffer layer between the light absorption layer and the transparent electrode layer, wherein the buffer layer comprises at least one material selected from the group consisting of cadmium sulfide (CdS), zinc sulfide (ZnS), and indium oxide (In₂O₃).

12. A solar cell according to any preceding claim, wherein:
the transparent electrode layer comprises a front surface for facing incident solar light; and
the front surface of the transparent electrode layer has a second surface-roughness separate from the first surface-roughness.

13. A solar cell according to any preceding claim, wherein the transparent electrode layer comprises at least one material selected from the group consisting of zinc oxide doped with boron (BZO), zinc oxide (ZnO), indium oxide (In₂O₃), and indium tin oxide (ITO).
